# EUROPEAN PATENT APPLICATION

(11) **EP 3 306 951 A2**
(43) Date of publication of application: **11.04.2018**
(21) Application number: 17195096.7
(22) Date of filing: 06.10.2017
(51) Int. Cl.: H04R 7/06, H04R 7/10, H04R 17/02, H04R 31/00

(54) **MICROPHONE AND METHOD FOR MANUFACTURING THE SAME**

(30) Priority: 07.10.2016 KR 20160130011
(71) Applicant: Research & Business Foundation Sungkyunkwan University, Suwon-si, Gyeonggi-do 440-746 (KR); BSE Co., Ltd., Incheon (KR)
(72) Inventor: KIM, Sang Woo, Gyeonggi-do (KR); KIM, Chang Won, Incheon (KR); KIM, Yong Kook, Seoul (KR); KIM, Sung Kyun, Gyeonggi-doGyeonggi-do (KR); KIM, Tae Yun, Incheo (KR); KIM, Tae Ho, Seoul (KR); KIM, Han, Seoul (KR); KANG, Minki, Gyeonggi-do (KR); CHOI, Seung, Gyeonggi-do (KR)
(74) Representative: Seppo Laine Oy

(57) **Abstract**

There is provided a microphone device comprising: a substrate (10) having top and bottom portions, wherein the substrate (10) has a cavity defined therein, wherein the cavity is open at the bottom portion of the substrate (10); a two-dimensional piezoelectric layer (20) disposed on the top portion of the substrate (10), wherein the two-dimensional piezoelectric layer (20) blocks a top of the cavity; and first and second electrode layers (30) respectively arranged on both lateral end portions of the two-dimensional piezoelectric layer (20), wherein the first and second spaced electrode layers (30) are spaced apart and electrically insulated from each other, wherein an electric potential energy is generated between the first and second electrode layers (30) via piezoelectricity of the two-dimensional piezoelectric layer (20) when the two-dimensional piezoelectric layer (20) vibrates by sound energy applied thereto, wherein the piezoelectricity is generated in a parallel direction to a plane of the two-dimensional piezoelectric layer (20).

## Description

### CROSS-REFERENCE TO RELATED APPLICATION

This application claims the benefit of Korean patent application No. 10-2016-0130011 filed on October 7, 2016, the entire content of which is incorporated herein by reference for all purposes as if fully set forth herein.

### BACKGROUND

### Field of the Present Disclosure

The present disclosure relates to a microphone and a method of manufacturing the same. More specifically, the present invention relates to a microphone using a two-dimensional material having piezoelectricity, and a manufacturing method thereof.

### Discussion of Related Art

A microphone is a device that produces an electrical signal representing a frequency of a sound. Such a device generates an AC induction current that represents the frequency of an input sound using a sound source, for example, a sound pressure vibrating a diaphragm. In recent years, a micro-scale microphone, which is thinner, lighter and consumes less power than a conventional microphone, has been actively applied with advance of MEMS techniques. The micro-scale microphone is widely used in earphones and headphones.

Generally, the most widely used approach for the microphone is a dynamic approach. In this approach, since a coil and the permanent magnet are used, the size of the microphone is large and the manufacturing cost thereof is high. Because of its large size, such a device is difficult to be embed in a certain device. Therefore, in order to overcome this problem, recently, a micro-scale microphone is integrated on a silicon wafer using a semiconductor processing method such as MEMS (micro electro mechanical system) process.

In addition to the dynamic approach, the microphone may be implemented in a capacitive or a condenser manner. In this approach, as a spacing between two parallel plates (stationary plate and diaphragm) facing away each other changes, a change in a capacitance is detected. In a microphone using the condenser approach, a constant voltage must be applied thereto during operation thereof in order to secure the charge amount. In order to obtain high sensitivity, the applied voltage must be large. However, if the applied voltage is large, the static deformation of the diaphragm becomes large, which leads to a reduction in impact resistance and a reduction in dynamic measurement range. Further, the diaphragm material is typically a dielectric such as a polysilicon nitride film, a silicon oxide film, or a polysilicon. Therefore, due to properties of this material itself, if the diaphragm is too thin, its mechanical strength is low, while if it is too thick, it may break. In addition, for high sensitivity, the spacing between the two parallel plates is quite narrow. Thus, this type of the microphone is vulnerable to external environments such as shock, vibration, and moisture.

There is an ECM (Electret Condenser Microphone) approach which is similar to the condenser approach. The ECM uses the diaphragm or fixed plate made of the dielectric in which static charges are arranged. In this way, the dielectric has a permanent electrical polarization, so that the microphone does not need to receive a constant voltage from the outside. In addition, these types of microphones are inexpensive and suitable for small mobile devices because they are inexpensive and easy to manufacture. However, the response characteristic thereof is low. When using the polymer as the diaphragm thereof, there is a temperature limitation, and, thus, the microphone cannot be mounted directly on the surface of the PCB.

Furthermore, the diaphragm may employ ceramic based piezoelectric materials such as PZT (PbZr₁₋ₓTiₓO₃), SBT (SrBi₂Ta₂O₉), BLT (Bi₄₋ₓLaₓTi₃O₁₂), PbTiO₃, BaTiO₃ or a polymers such as PVDF (polyvinylidene fluoride) having piezoelectric properties. When the piezoelectric material is used, the microphone may be driven at a low voltage and is advantageous in downsizing and thinning. However, there is a disadvantage in that the sound output and sensitivity are lower than those of a conventional microphone using a coil and an electromagnet. When the piezoelectric ceramic is used, the microphone is heavy and fragile since it is not bent. In addition, the material containing a lead Pb is harmful to the human body. In addition, when PVDF, which is a ferroelectric polymer, is used, there is a limitation in operation temperature of the diaphragm. This polymer material is not suitable for DC measurement, and the piezoelectric characteristic thereof is lower than that of the ceramic material. Especially, since beta-phase PVDF having piezoelectric properties should be used, heat treatment is essential. Further, aging may occur in which output is lowered over time.

### SUMMARY

This Summary is provided to introduce a selection of concepts in a simplified form that are further described below in the Detailed Description. This Summary is not intended to identify all key features or essential features of the claimed subject matter, nor is it intended to be used alone as an aid in determining the scope of the claimed subject matter.

The present disclosure is to provide a micro-scale microphone using a two-dimensional material having piezoelectric characteristics in order to solve the above-mentioned problems.

The present invention is to provide a very thin and highly-sensitive micro-scale microphone based on a two-dimensional material with piezoelectric properties.

The present invention is to provide a micro-scale microphone using a two-dimensional piezoelectric material as a diaphragm.

In a first aspect of the present disclosure, there is provided a microphone device comprising: a substrate having top and bottom portions, wherein the substrate has a cavity defined therein, wherein the cavity is open at the bottom portion of the substrate; a two-dimensional piezoelectric layer disposed on the top portion of the substrate, wherein the two-dimensional piezoelectric layer blocks a top of the cavity; and first and second electrode layers respectively arranged on both lateral end portions of the two-dimensional piezoelectric layer, wherein the first and second spaced electrode layers are spaced apart and electrically insulated from each other, wherein an electric potential energy is generated between the first and second electrode layers via piezoelectricity of the two-dimensional piezoelectric layer when the two-dimensional piezoelectric layer vibrates by sound energy applied thereto, wherein the piezoelectricity is generated in a parallel direction to a plane of the two-dimensional piezoelectric layer.

In one implementation of the first aspect, the device may further include an insulating layer disposed between the substrate and the two-dimensional piezoelectric layer.

In one implementation of the first aspect, the two-dimensional piezoelectric layer includes at least one selected from a group consisting of a transition metal dicalcogenide, alkaline earth metal oxides, and group 3-5 compounds.

In one implementation of the first aspect, a thickness of the two-dimensional piezoelectric layer is smaller than or equal to 1 nm.

In one implementation of the first aspect, a resonance frequency of the two-dimensional piezoelectric layer is greater than or equal to 20 kHz.

In one implementation of the first aspect, the two-dimensional piezoelectric layer includes MoS₂.

In one implementation of the first aspect, the two-dimensional piezoelectric layer comprises a stack of two-dimensional piezoelectric sub-layers.

In a second aspect of the present disclosure, there is provided a microphone device comprising: a substrate having top and bottom portions, wherein the substrate has an array of n x m cavities defined therein, wherein n and m are integers equal to or larger than 2, wherein the cavities are open at the bottom portion; an array of n x m two-dimensional piezoelectric layers arranged on the top portion, wherein the n x m two-dimensional piezoelectric layers are arranged to block tops of the n x m cavities respectively; and first and second spaced electrode patterns disposed on the array of the two-dimensional piezoelectric layers, wherein the first electrode pattern includes first electrode sub-lines arranged parallel to each other and spaced from each other, and the second electrode pattern includes second electrode sub-lines arranged parallel to each other and spaced from each other, wherein the first electrode sub-lines are alternated with the second electrode sub-lines, wherein one first electrode sub-line and one second electrode sub-line are respectively arranged on both lateral end portions of each two-dimensional piezoelectric layer, and are spaced apart and electrically insulated from each other, wherein an electric potential energy is generated between the first and second electrode sub-lines via piezoelectricity of each two-dimensional piezoelectric layer when each two-dimensional piezoelectric layer vibrates by sound energy applied thereto, wherein the piezoelectricity is generated in a parallel direction to a plane of each two-dimensional piezoelectric layer.

In one implementation of the second aspect, the device may further include an insulating layer disposed between the substrate and the array of the two-dimensional piezoelectric layers.

In one implementation of the second aspect, each of the two-dimensional piezoelectric layers includes at least one selected from a group consisting of a transition metal dicalcogenide, alkaline earth metal oxides, and group 3-5 compounds.

In one implementation of the second aspect, a thickness of each of the two-dimensional piezoelectric layers is smaller than or equal to 1 nm.

In one implementation of the second aspect, a resonance frequency of each of the two-dimensional piezoelectric layers is greater than or equal to 20 kHz.

In one implementation of the second aspect, each of the two-dimensional piezoelectric layers includes MoS₂.

In one implementation of the second aspect, each of the two-dimensional piezoelectric layers comprises a stack of two-dimensional piezoelectric sub-layers.

In a third aspect of the present disclosure, there is provided a method for manufacturing a microphone device, the method comprising providing a substrate having top and bottom portions; forming a two-dimensional piezoelectric layer on the top portion of the substrate; patterning and etching the two-dimensional piezoelectric layer such that the two-dimensional piezoelectric layer is present only in a region thereof corresponding to a cavity to be formed; forming first and second spaced electrode layers on the two-dimensional piezoelectric layer; and etching the substrate such that the cavity is defined in the substrate, and the cavity is open at the bottom portion of the substrate, wherein the two-dimensional piezoelectric layer blocks a top of the cavity.

In one implementation of the third aspect, the method may further include forming an insulating layer disposed between the substrate and the two-dimensional piezoelectric layer.

In one implementation of the third aspect, the method may further include etching the insulating layer such that the cavity is defined in the insulating layer.

In one implementation of the third aspect, the method may further include forming a protective layer on the two-dimensional piezoelectric layer and the electrode layers prior to the etching of the substrate.

In a fourth aspect of the present disclosure, there is provided a method for manufacturing a microphone device, the method comprising providing a substrate having top and bottom portions; forming a two-dimensional piezoelectric layer on the top portion of the substrate; patterning and etching the two-dimensional piezoelectric layer such that an array of n x m two-dimensional material sub-layers are defined; forming first and second electrode patterns on the array of the n x m two-dimensional material sub-layers; and etching the substrate such that an array of n x m cavities is defined in the substrate, and the cavities is open at the bottom portion of the substrate, and a top of each cavity is blocked by each two-dimensional material sub-layer block.

In one implementation of the fourth aspect, forming the first and second electrode patterns comprising: forming an electrode layer on the array of the n x m two-dimensional material sub-layers; and patterning and etching the electrode layer such that the first electrode pattern includes first electrode sub-lines arranged parallel to each other and spaced from each other, and the second electrode pattern includes second electrode sub-lines arranged parallel to each other and spaced from each other, wherein the first electrode sub-lines are alternated with the second electrode sub-lines, wherein one first electrode sub-line and one second electrode sub-line are respectively arranged on both lateral end portions of each two-dimensional piezoelectric layer, and are spaced apart and electrically insulated from each other.

According to the present invention, the microphone device based on the two-dimensional material having piezoelectric characteristics is extremely thin and excellent in sensitivity.

According to the present invention, by using the thin two-dimensional material having a mono-atomic layer scale as the diaphragm, the microphone having a very high sensitivity can be manufactured.

The microphone according to the present invention may be a sufficient substitute for conventional capacitive MEMS microphones because the diaphragm of the present microphone device is not deformed or degraded even at the temperatures required by surface mount technology (SMT).

### BRIEF DESCRIPTION OF THE DRAWINGS

The accompanying drawings, which are incorporated in and form a part of this specification and in which like numerals depict like elements, illustrate embodiments of the present disclosure and, together with the description, serve to set forth the principles of the disclosure.
FIG. 1 is a schematic diagram illustrating a structure of a microphone according to an embodiment of the present invention.
FIG. 2 is a typical schematic diagram showing a structure of MoS2 as a two-dimensional material.
FIG. 3 shows a schematic diagram showing that the two-dimensional piezoelectric layer is deformed by externally applied sound energy thereto, and a schematic diagram showing generation of electrical potential from sound pressure using piezoelectric characteristics, according to an embodiment of the present invention.
FIG. 4 is a schematic diagram showing a structure of a microphone according to a further embodiment of the present invention.
FIG. 5 shows a flowchart of a method for manufacturing a microphone according to an embodiment of the present invention.
FIG. 6 illustrates structures respectively corresponding to operations of a method for manufacturing a microphone according to an embodiment of the present invention.
FIG. 7a to FIG. 7d show various configurations of functional microphone devices according to various embodiment of the present invention.

### DETAILED DESCRIPTIONS

For simplicity and clarity of illustration, elements in the figures are not necessarily drawn to scale. The same reference numbers in different figures denote the same or similar elements, and as such perform similar functionality. Also, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

It will be understood that, although the terms "first", "second", "third", and so on may be used herein to describe various elements, components, regions, layers and/or regions, these elements, components, regions, layers and/or regions should not be limited by these terms. These terms are used to distinguish one element, component, region, layer or region from another element, component, region, layer or region. Thus, a first element, component, region, layer or region described below could be termed a second element, component, region, layer or region, without departing from the spirit and scope of the present disclosure.

It will be understood that when an element or layer is referred to as being "connected to", or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

Spatially relative terms, such as "beneath," "below," "lower," "under," "above," "upper," and the like, may be used herein for ease of explanation to describe one element or feature's relationship to another element s or feature s as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented for example, rotated 90 degrees or at other orientations, and the spatially relative descriptors used herein should be interpreted accordingly.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "includes", "including", "includes", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of' when preceding a list of elements may modify the entire list of elements and may not modify the individual elements of the list.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the following description, numerous specific details are set forth in order to provide a thorough understanding of the present disclosure. The present disclosure may be practiced without some or all of these specific details. In other instances, well-known process structures and/or processes have not been described in detail in order not to unnecessarily obscure the present disclosure.

As used herein, the term "substantially," "about," and similar terms are used as terms of approximation and not as terms of degree, and are intended to account for the inherent deviations in measured or calculated values that would be recognized by those of ordinary skill in the art. Further, the use of "may" when describing embodiments of the present disclosure refers to "one or more embodiments of the present disclosure."

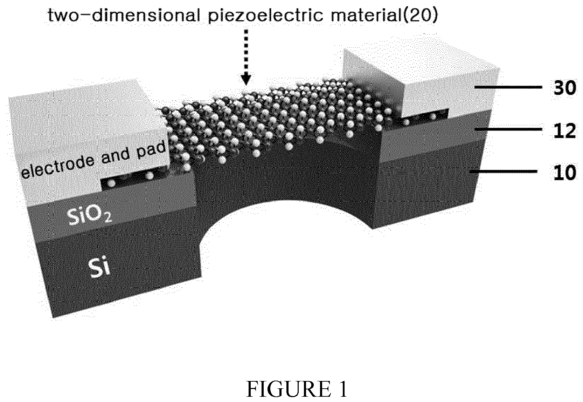

FIG. 1 is a schematic diagram illustrating a structure of a microphone according to an embodiment of the present invention. Referring to FIG. 1, the microphone using a two-dimensional material with piezoelectric properties may include a substrate 10 having a cavity defined therein, a two-dimensional piezoelectric layer 20, and first and second spaced electrode layers 30.

The substrate 10 may further include an insulating layer 12 disposed on the substrate. The insulating layer 12 also has a cavity formed therein. In this case, the cavity formed in the insulating layer 12 may communicate with and overlap vertically a cavity formed in the substrate 10.

The two-dimensional piezoelectric layer 20 is disposed on the substrate 10 to block a top of the cavity. The two-dimensional piezoelectric layer acts as a diaphragm. That is, as the two-dimensional piezoelectric layer vibrates due to sound, the two-dimensional piezoelectric layer generates an electric potential energy.

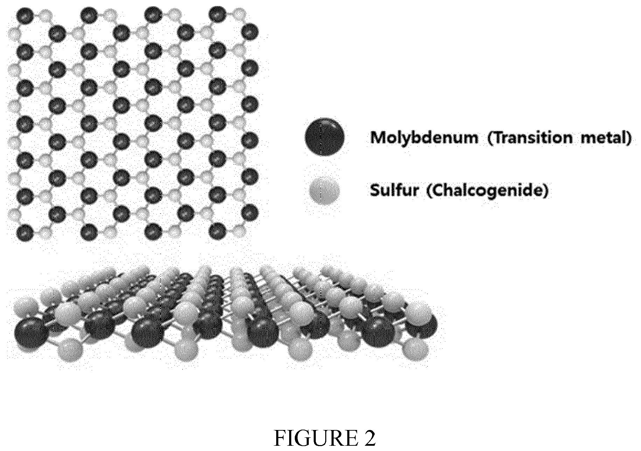

The two-dimensional piezoelectric layer may include a variety of materials. As the two-dimensional material, graphene composed of a single element may be used. In addition, studies on peeling and synthesis of mixtures of various materials on the periodic table of the elements as the two-dimensional material are actively conducted. Among these mixture, a mixture which is studied as actively as the graphene is TMD (Transition Metal Dichalcogenide) material composed of two elements. The TMD material has semiconductor properties. The TMD is configured such that a transition metal and chalcogen atoms together form a hexagonal structure with covalent bonds therebetween, as shown in FIG. 2. The TMD has a piezoelectric characteristic due to the asymmetric structure thereof. Examples of the TMD may include MoS₂, MoSe₂, MoTe₂, WS₂, WSe₂, WTe2 and the like. In addition, alkaline earth metal oxides (CdO, ZnO, CaO, MgO) and group 3-5 compounds (BN, InAs, InP, AlAs) may be used as the two-dimensional piezoelectric material.

In accordance with the present invention, a micro-scale microphone is manufactured using a two-dimensional non-sheet made of a two-dimensional piezoelectric material having piezoelectric characteristics. In particular, embodiments of the present invention are described based on a two-dimensional TMD nano-sheet. However, the present invention is not limited to this. A structure and operation of the micro-scale microphone using the two-dimensional TMD nano-sheet are also applied to a structure and operation of a microphone manufactured using two-dimensional piezoelectric materials other than the TDM. A thickness of the two-dimensional TMD nano-sheet is about 1 nm or less. Using the nano-sheet having such a thickness, an ultra-sensitive microphone having a diaphragm having a thickness non-comparable to that of a conventional microphone may be manufactured.

When the diaphragm of the microphone is large and heavy, this may degrade the sound quality thereof. The diaphragm, which has a large area, is subject to air resistance, which causes the sound to become unclear. Thus, a micro-scale microphone manufactured according to the present invention may employ a very thin two-dimensional material of a mono-atomic layer scale as the diaphragm. Therefore, the microphone having a very high sensitivity may be manufactured in accordance with the present invention.

In addition, the two-dimensional material has a high strength and thus may replace a conventional diaphragm. In particular, a strength of MoS2 as one of the two-dimensional materials is described in a document "Stretching and Breaking of Ultrathin MoS₂, ACS Nano, 2011, 12, 9703-9709". An effective Young's modulus of this material averages about 255 GPa. This value has been reported to be comparable to that for a steel. Therefore, the material MoS₂ allows a thin film with a very strong elasticity, which is sufficient to replace the existing diaphragm.

The microphone according to the present invention does not use a fixed plate required in a conventional capacitive type microphone because the present microphone uses a piezoelectric property of the diaphragm made of the two-dimensional piezoelectric layer. Therefore, noise reduction and manufacturing process steps can be reduced. In addition, since an external voltage is not used, there is an advantage that a signal processing circuit in the microphone can be simplified. Further, when the microphone according to the present invention is used, the microphone generates electrical potential energy on its own, so that there is no need to continuously flow external current thereto. Therefore, it has an advantage that the power consumption thereof is very small.

According to the present invention, it is preferable that a resonance frequency of the two-dimensional piezoelectric layer is higher than 20 kHz. The resonance frequency of a membrane using MoS2 as the two-dimensional piezoelectric material is more than or equal to 20 kHz. Therefore, a microphone that can be used in an ultrasonic range of 20 kHz or more can be achieved.

According to one embodiment, the two-dimensional piezoelectric layer may include a plurality of layers. That is, a plurality of the two-dimensional piezoelectric layers may overlap each other. This may lead to an improvement in the characteristics of the piezoelectric effect.

A material for the first and second spaced electrode layers 30 is not particularly limited as long as the material realizes electrode characteristics. The first and second spaced electrode layers 30 are respectively arranged on both lateral end portions of the two-dimensional piezoelectric layer. The first and second spaced electrode layers 30 are spaced apart from each other. Thus, the first and second spaced electrode layers are insulated from each other. The arrangement of the first and second spaced electrode layers results in that an electric potential is generated using piezoelectric characteristics parallel (that is, in a direction of d11) to a plane of the two-dimensional piezoelectric layer when the two-dimensional piezoelectric layer vibrates by sound energy.

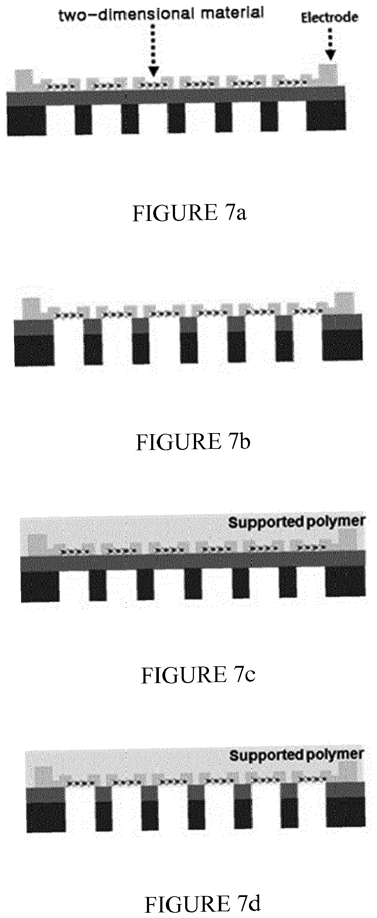

Referring to FIG. 7c and FIG. 7d, according to one embodiment, in order to protect the two-dimensional piezoelectric layer, a protective polymer layer may be coated on the two-dimensional piezoelectric layer.

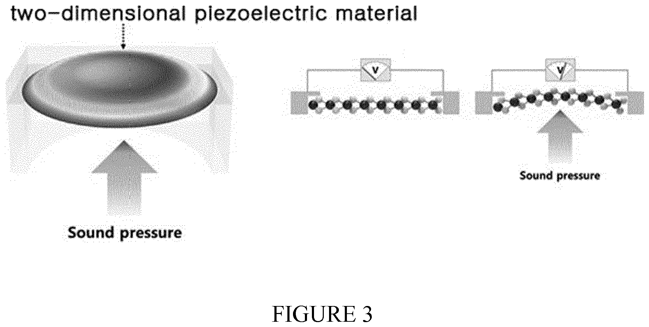

In a microphone according to an embodiment of the present invention, as the two-dimensional piezoelectric layer vibrates by sound energy, an electric potential is generated. FIG. 3 shows a schematic diagram showing that the two-dimensional piezoelectric layer is deformed by externally applied sound energy thereto, and a schematic diagram showing generation of electrical potential from sound pressure using piezoelectric characteristics, according to an embodiment of the present invention.

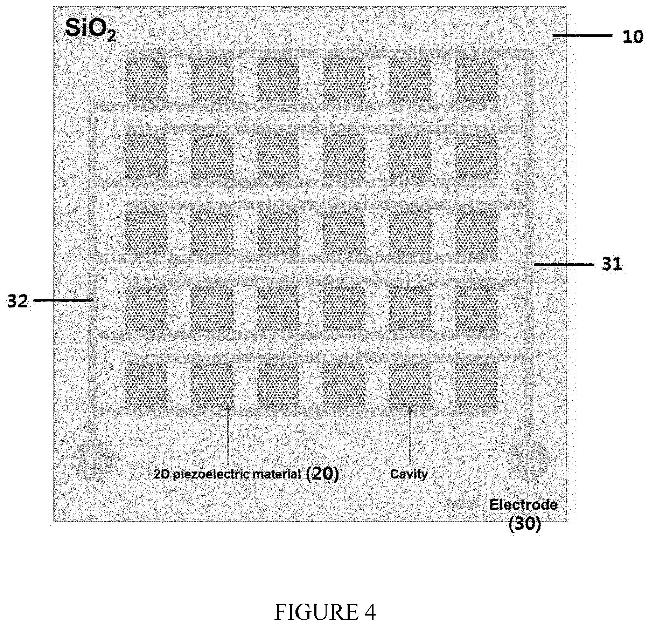

According to another embodiment of the present invention, a microphone using the two-dimensional piezoelectric material may have a structure as shown in FIG. 4. That is, although the microphone using the two-dimensional piezoelectric material may have a single functional element structure as shown in FIG. 1, the present invention is not limited to this. That is, referring to FIG. 4, a plurality of cavities may be defined in the substrate 10 in an array form. Thus, a plurality of two-dimensional piezoelectric layers in an array from blocks tops of the cavities respectively. By implementing such an array-type microphone, higher sensitivity and output can be improved.

Hereinafter, an array type microphone using the two-dimensional piezoelectric material as shown in FIG. 4 will be described. Duplicated descriptions will be omitted with respect to the same portions as those as described above.

The microphone using the two-dimensional piezoelectric material has an array structure. The array type microphone may include a substrate having an array of n x m (n and m being an integer greater than or equal to 2) cavities defined in the substrate; a plurality of two-dimensional piezoelectric layers arranged to block the plurality of cavities respectively; and first and second spaced electrode layers disposed on each of the plurality of the two-dimensional piezoelectric layers.

Referring to FIG. 4, the substrate has an array of n x m (n and m being an integer greater than or equal to 2) cavities defined in the substrate. These cavities may be arranged in an array form. In one example, the array may include a 6x5 cavities array.

The plurality of two-dimensional piezoelectric layers are arranged in an array form to block the plurality of cavities respectively. That is, the number of the two-dimensional piezoelectric layers is equal to the number of the cavities. In one example, the array of the two-dimensional piezoelectric layers may include an array of 6x5 two-dimensional piezoelectric layers.

The first and second spaced electrode layers may be disposed on each of the plurality of the two-dimensional piezoelectric layers. The first and second spaced electrode layers may be disposed respectively on both lateral end potions of each of the plurality of the two-dimensional piezoelectric layers.

In this connection, with respect to the array form of the cavities and the array form of the two-dimensional piezoelectric layers, the first and second spaced electrode layers may have a special arrangement.

In one embodiment, as shown in FIG. 4, the first and second spaced electrode layers may be configured such that the first electrode layer corresponds to a first electrode pattern 31, and the first electrode layer corresponds to a second electrode pattern 32. The first electrode pattern and the second electrode pattern 31 and 32 are spaced apart and electrically isolated from each other. The first electrode pattern and the second electrode pattern 31 and 32 may form an interdigitated electrode pattern. In other words, the first electrode pattern and the second electrode pattern 31 and 32 are interdigitated with each other.

As shown in FIG. 4, the first electrode pattern and the second electrode pattern 31 and 32 may form an interdigitated electrode pattern, wherein the first electrode pattern and the second electrode pattern 31 and 32 are interdigitated with each other. More strictly, the first electrode pattern 31 includes first electrode sub-lines arranged parallel to each other and spaced from each other. The second electrode pattern 32 includes second electrode sub-lines arranged parallel to each other and spaced from each other. The first electrode sub-lines are alternated with the second electrode sub-lines.

Hereinafter, a method of manufacturing the microphone as described above will be described. Duplicated descriptions will be omitted with respect to the same portions as those as described above.

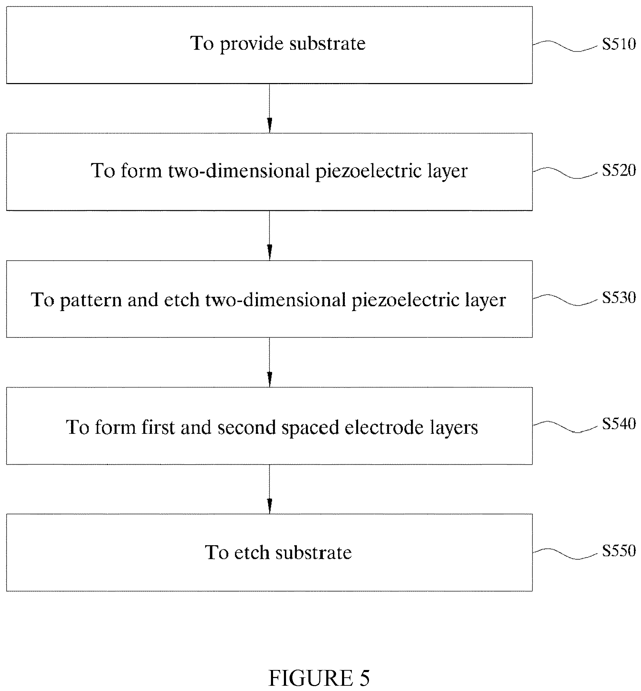

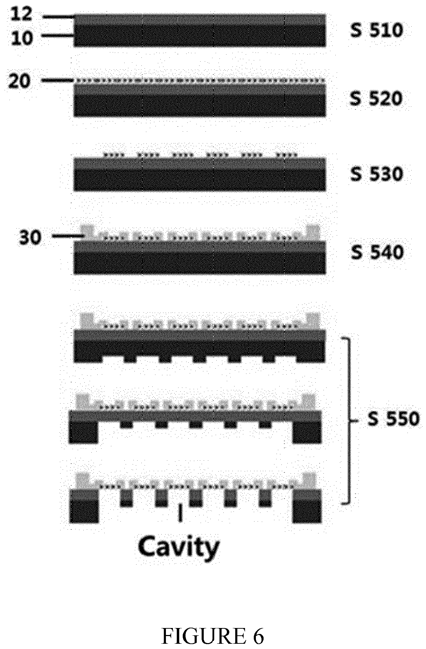

FIG. 5 shows a flowchart of a method for manufacturing a microphone according to an embodiment of the present invention. FIG. 6 illustrates structures respectively corresponding to operations of a method for manufacturing a microphone according to an embodiment of the present invention.

A method for manufacturing a microphone according to an embodiment of the present invention includes: an operation S 510 of providing a substrate having top and bottom portions; an operation S 520 of forming a two-dimensional piezoelectric layer on the top portion of the substrate; an operation S 530 of patterning and etching the two-dimensional piezoelectric layer such that the two-dimensional piezoelectric layer is present only in regions thereof corresponding to cavities; an operation S 540 of forming first and second spaced electrodes on the two-dimensional piezoelectric layer; and an operation S 550 of etching the substrate such that the cavities are defined in the substrate in regions thereof corresponding to the cavities, wherein the cavities are open at the bottom portion.

In the S 510 operation, the substrate 10 having top and bottom portions is prepared. On the top portion of the substrate 10, an insulating layer 12 may be further formed. In one example, the substrate may be implemented as a Si substrate, and the insulating layer may be implemented as SiO₂. The present invention is not limited thereto.

In the S 520 operation, the two-dimensional piezoelectric layer 20 is formed on the top portion of the substrate 10. The formation of the two-dimensional piezoelectric layer 20 may be achieved by chemical vapor deposition (CVD), or may be accomplished by a sputtering method. The present invention is not necessarily limited thereto.

In the operation S 530, the two-dimensional piezoelectric layer is patterned and etched such that the two-dimensional piezoelectric layer is present only in regions thereof corresponding to the cavities. The patterning is performed using a photolithography process, and the etching is performed using a plasma etching process after the irradiation of UV to the patterned layer. The present invention is not necessarily limited thereto.

In the operation S 540, the first and second spaced electrodes 30 are formed on the two-dimensional piezoelectric layer. The formation of the electrode layers is performed as follows: An electrode layer is deposited using a sputtering equipment or evaporation equipment, and, then, portions of the electrode other than necessary electrode potions are removed by a lift-off method. The present invention is not necessarily limited.

In the operation S 550, the substrate 10 is etched such that the cavities are defined in the substrate 10 in regions thereof corresponding to the cavities, wherein the cavities are open at the bottom portion.

This etching of the substrate may be performed after a protective layer is coated on the two-dimensional piezoelectric layer and the electrode layers. The substrate may be etched by first etching using DRIE or wet etching, and second etching using DRIE or wet etching. When the insulating layer is formed of SiO₂, SiO₂ is removed using vapor or aqueous solution made of HF.

In the S 550 operation, the cavities may be formed in the substrate 10 and the insulating layer 12. The insulating layer 12 also has a cavity formed therein. In this case, the cavity formed in the insulating layer 12 may communicate with and overlap vertically a cavity formed in the substrate 10.

Meanwhile, various configurations of the functional microphone device may be achieved according to etching schemes and orders in the S 550 operation. The various configurations of the functional microphone device are shown in FIG. 7a to FIG. 7d.

In FIG. 7a, the insulating layer is not etched. In this case, a functional microphone device is achieved in which the two-dimensional piezoelectric layer and the insulating layer oscillate together. In FIG. 7b, the insulating layer is etched. In this case, a functional microphone device is achieved in which only the two-dimensional piezoelectric layer vibrates.

FIG. 7c and FIG. 7d illustrate, respectively, variations of functional microphone devices of FIG. 7a and FIG. 7b in which a protective polymer layer is further present to protect the two-dimensional piezoelectric layer.

The two-dimensional piezoelectric layer is preferably made of any one of the transition metal dicalcogenide, an alkaline earth metal oxides, and group 3-5 compounds. The thickness of the two-dimensional piezoelectric layer is preferably 1 nm or less.

As described above, in the case of fabricating the array type microphone using the two-dimensional piezoelectric material, the plurality of cavities are formed, and a two-dimensional piezoelectric layer is patterned and etched so as to position-correspond to the plurality of cavities. Thus, the two-dimensional piezoelectric layer is patterned and etched so that the two-dimensional piezoelectric layer exists only in regions thereof corresponding to the plurality of cavities.

Further, in the case of fabricating the array type microphone, the first and second spaced electrode layers may be configured such that the first electrode layer corresponds to a first electrode pattern 31, and the first electrode layer corresponds to a second electrode pattern 32. The first electrode pattern and the second electrode pattern 31 and 32 are spaced apart and electrically isolated from each other. The first electrode pattern and the second electrode pattern 31 and 32 may form an interdigitated electrode pattern. In other words, the first electrode pattern and the second electrode pattern 31 and 32 are interdigitated with each other. More strictly, the first electrode pattern 31 includes first electrode sub-lines arranged parallel to each other and spaced from each other. The second electrode pattern 32 includes second electrode sub-lines arranged parallel to each other and spaced from each other. The first electrode sub-lines are alternated with the second electrode sub-lines.

Hereinafter, specific examples of the present invention will be further described.

### [Example 1]

As the two-dimensional piezoelectric layer, the TMD nano-sheet material employs the most widely known MoS2 material. More specifically, large-area MoS2 synthesized using CVD (Chemical Vapor Deposition) is used for mass production and commercialization.

Sputtering or evaporation is used to deposit the electrode layer. A photo-lithography process is used for patterning. DRIE (Deep Reactive Ion Etching) or wet etching is used for etching.

### 1) Synthesis of Large-Area MoS2 by Chemical Vapor Deposition (CVD)

A small amount of MoO₃ powder is injected into a ceramic boat which is placed in a center of a quartz tube. At this time, the amount of MoO₃ powder is adjusted based on the number or size of the SiO₂ substrates. A washed SiO₂ substrate is placed on the boat. The interior of the quartz tube is vacuumed using a rotary pump. A high-purity Ar gas is introduced into the tube at 200 sccm. The pressure in the tube is adjusted to 10 Torr. The temperature in a CVD chamber is heated to 700 degree C for about 30 minutes. When the temperature reaches 700 degree C, 5 sccm of H₂S gas is introduced into the chamber. The pressure is continuously kept at 10 Torr. MoS₂ grows on the substrate for about 15 minutes. At this time, the amount of H₂S gas and the growth time are adjusted based on the number or size of the SiO₂ substrates.

When the MoS₂ layer growth is completed, the H₂S gas injection is cut off and the CVD chamber is naturally cooled down to room temperature.

### 2) Patterning of upper portion of MoS₂ layer and formation of electrode pad

A photolithography process is used to pattern the grown MoS₂ nano-sheet into an array of square sheets. At this time, a size of the square sheet and a spacing between the square sheets may be adjusted based on a target microphone size.

To leave the MoS₂ square sheet, a positive lithography method is used. After UV irradiation and development are carried out, remaining MoS₂ portions other than the square sheet are etched using a plasma etching process. A gas used to etch the MoS₂ sheet is a mixture of CF₄ and O₂.

Remaining photoresist is removed using acetone or PR remover solution.

An electrode layer is deposited using sputtering or evaporation on the array of the square sheets. Then, the electrode layer is patterned using a negative lithography process. Using acetone or PR remover solution, electrode layer portions other than necessary electrodes are removed by a lift-off method.

### 3) First etching using DRIE or wet etching

A protective layer is formed on a top portion of the substrate by spin coating using a polymer or a PR solution.

To form cavities in the substrate, target size cavities are patterned in the Si substrate using a negative lithography process such that the cavities are open at a bottom portion of the substrate. The patterned substrate is developed using a developer.

Using a DRIE equipment, the Si substation is partially etched shallowly. At this time, the etching depth is suitably in a range of 5 to 50 µm.

Alternatively, the patterned Si substrate is partially etched using a wet etching method using a solution of KOH, TMAH, or the like.

### 4) Second etching using DRIE or wet etching

To etch the remaining Si silicon portions, the DRIE process or wet etching is repeated again.

### 5) Etching of SiO₂ insulating layer using HF vapor

In order to make the MoS₂ sheet floating on the cavities, the insulating layer SiO₂ is removed. At this time, since the two-dimensional material is damaged by the plasma in case of the plasma etching, the insulating layer SiO₂ is necessarily removed not by the plasma etching but by using an aqueous solution such as HF or its vapor.

The above embodiments of the present disclosure is merely for the illustration of the present disclosure and is not for the limitation of the present disclosure. The features presented in the above embodiments of the present disclosure may be combined with or substituted with one another to form various modifications. It should be noted that these modifications may be regarded as falling into the scope of the present disclosure. The present disclosure will be embodied in various forms within the scope of the claims and their equivalents. Those skilled in the art will appreciate that various embodiments are possible within the scope or sprit of the present disclosure.

## Claims

1. A microphone device being **characterized in that** the device comprises:
a substrate (10) having top and bottom portions, wherein the substrate has a cavity defined therein, wherein the cavity is open at the bottom portion of the substrate;
a two-dimensional piezoelectric layer (20) disposed on the top portion of the substrate, wherein the two-dimensional piezoelectric layer blocks a top of the cavity; and
first and second electrode layers (30) respectively arranged on both lateral end portions of the two-dimensional piezoelectric layer, wherein the first and second spaced electrode layers are spaced apart and electrically insulated from each other,
wherein an electric potential energy is generated between the first and second electrode layers via piezoelectricity of the two-dimensional piezoelectric layer when the two-dimensional piezoelectric layer vibrates by sound energy applied thereto, wherein the piezoelectricity is generated in a parallel direction to a plane of the two-dimensional piezoelectric layer.

2. A microphone device being **characterized in that** the device comprises:
a substrate (10) having top and bottom portions, wherein the substrate has an array of n x m cavities defined therein, wherein n and m are integers equal to or larger than 2, wherein the cavities are open at the bottom portion;
an array of n x m two-dimensional piezoelectric layers (20) arranged on the top portion, wherein the n x m two-dimensional piezoelectric layers are arranged to block tops of the n x m cavities respectively; and
first and second spaced electrode patterns (31 and 32) disposed on the array of the two-dimensional piezoelectric layers,
wherein the first electrode pattern (31) includes first electrode sub-lines arranged parallel to each other and spaced from each other, and the second electrode pattern (32) includes second electrode sub-lines arranged parallel to each other and spaced from each other, wherein the first electrode sub-lines are alternated with the second electrode sub-lines, wherein one first electrode sub-line and one second electrode sub-line are respectively arranged on both lateral end portions of each two-dimensional piezoelectric layer, and are spaced apart and electrically insulated from each other,
wherein an electric potential energy is generated between the first and second electrode sub-lines via piezoelectricity of each two-dimensional piezoelectric layer when each two-dimensional piezoelectric layer vibrates by sound energy applied thereto, wherein the piezoelectricity is generated in a parallel direction to a plane of each two-dimensional piezoelectric layer.

3. The device of claim 1 or 2, further comprising an insulating layer (12) disposed between the substrate (10) and the two-dimensional piezoelectric layer (20).

4. The device of any one of the preceding claims, wherein the two-dimensional piezoelectric layer (20) includes at least one selected from a group consisting of a transition metal dicalcogenide, alkaline earth metal oxides, and group 3-5 compounds.

5. The device of any one of the preceding claims, wherein a thickness of the two-dimensional piezoelectric layer (20) is smaller than or equal to 1 nm.

6. The device of any one of the preceding claims, wherein a resonance frequency of the two-dimensional piezoelectric layer (20) is greater than or equal to 20 kHz.

7. The device of any one of the preceding claims, wherein the two-dimensional piezoelectric layer (20) includes MoS₂.

8. The device of any one of the preceding claims, wherein the two-dimensional piezoelectric layer (20) comprises a stack of two-dimensional piezoelectric sub-layers.

9. A method for manufacturing a microphone device, the method being **characterized in that** the method comprises:
(S 510) providing a substrate (10) having top and bottom portions;
(S 520) forming a two-dimensional piezoelectric layer (20) on the top portion of the substrate;
(S 530) patterning and etching the two-dimensional piezoelectric layer such that the two-dimensional piezoelectric layer is present only in a region thereof corresponding to a cavity to be formed;
(S 540) forming first and second spaced electrode layers (30) on the two-dimensional piezoelectric layer; and
(S 550) etching the substrate such that the cavity is defined in the substrate, and the cavity is open at the bottom portion of the substrate, wherein the two-dimensional piezoelectric layer blocks a top of the cavity.

10. The method of claim 9, further comprising forming an insulating layer (12) disposed between the substrate and the two-dimensional piezoelectric layer.

11. The method of claim 10, further comprising etching the insulating layer such that the cavity is defined in the insulating layer.

12. The method of any one of the preceding claims, further comprising forming a protective layer on the two-dimensional piezoelectric layer and the electrode layers prior to the etching of the substrate.

13. The method of any one of the preceding claims, wherein a thickness of the two-dimensional piezoelectric layer (20) is smaller than or equal to 1 nm.

14. A method for manufacturing a microphone device, the method being **characterized in that** the method comprises:
(S 510) providing a substrate (10) having top and bottom portions;
(S 520) forming a two-dimensional piezoelectric layer on the top portion of the substrate;
(S 530) patterning and etching the two-dimensional piezoelectric layer such that an array of n x m two-dimensional material sub-layers (20) are defined;
(S 540) forming first and second electrode patterns (31, 32) on the array of the n x m two-dimensional material sub-layers; and
(S 550) etching the substrate such that an array of n x m cavities is defined in the substrate, and the cavities are open at the bottom portion of the substrate, and a top of each cavity is blocked by each two-dimensional material sub-layer block.

15. The method of claim 14, wherein (S 540) forming the first and second electrode patterns comprising:
forming an electrode layer on the array of the n x m two-dimensional material sub-layers; and
patterning and etching the electrode layer such that the first electrode pattern includes first electrode sub-lines arranged parallel to each other and spaced from each other, and the second electrode pattern includes second electrode sub-lines arranged parallel to each other and spaced from each other, wherein the first electrode sub-lines are alternated with the second electrode sub-lines, wherein one first electrode sub-line and one second electrode sub-line are respectively arranged on both lateral end portions of each two-dimensional piezoelectric layer, and are spaced apart and electrically insulated from each other.
